# EUROPEAN PATENT SPECIFICATION

(11) **EP 2 582 214 B1**
(45) Date of publication and mention of the grant of the patent: **26.11.2014**
(21) Application number: 12188121.3
(22) Date of filing: 11.10.2012
(51) Int. Cl.: H05K 1/09, C09D 11/00, H05K 3/12, H01L 23/482

(54) **Method for Forming Conductive Circuit**
Verfahren zum Bilden einer leitfähigen Schaltung
Procédé de réalisation d'un circuit conducteur

(30) Priority: 13.10.2011 JP 2011225661
(43) Date of publication of application: 17.04.2013
(73) Proprietor: Shin-Etsu Chemical Co., Ltd., Chiyoda-ku Tokyo (JP)
(72) Inventor: Hamada, Yoshitaka, Joetsu-shi, Niigata (JP); Yamakawa, Naoki, Annaka-shi, Gunma (JP)
(74) Representative: Ter Meer Steinmeister & Partner

(56) References cited:
- WO-A1-2006/093398
- WO-A1-2009/075520
- FR-A1- 2 501 221
- JP-A- 2007 053 109
- US-A- 3 484 284

## Description

### TECHNICAL FIELD

This invention relates to a method for forming a conductive circuit using a conductive ink composition, and more particularly to a method for forming a cured silicone-based conductive circuit by a printing technique. As used herein, the term "conductive" refers to electrical conduction.

### BACKGROUND ART

The technology of forming a conductive circuit by printing an ink composition containing conductive particles is already commercially implemented, for example, in the solar cell application wherein a conductive circuit is formed on a cell substrate by screen printing. A number of improvements in this technology have been proposed. For example, Patent Document 1 discloses that a conductive ink composition containing metal particles and glass frit, which is commonly used in the art, is printed by screen printing with the aid of ultrasonic oscillation. This method enables high speed formation of conductive circuits.

A problem arises when a circuit is formed on a semiconductor circuit board using a conductive ink composition based on glass. If the board is heated after circuit formation for substrate bonding or packaging purpose, the conductive ink composition may be cracked or otherwise stressed to cause a resistance change or breakage to the conductor. There is a need for a circuit-forming material having high stress resistance. Silicone material is characterized by heat resistance and stress relaxation. Patent Document 2 discloses that an ink composition comprising a thermoplastic resin, epoxy-modified silicone, metal powder, and silicone rubber elastomer is diluted with a solvent and used to form a conductive circuit which is not cracked or adversely affected on heat treatment.

The current trend is toward miniaturization of semiconductor circuits, and the size of concomitant conductive circuits also becomes finer. Also efforts are made on the so-called 3D semiconductor device, that is, a stacked semiconductor circuit structure obtained by forming a semiconductor circuit on a substrate, and stacking two or more such substrates. When such fine semiconductor circuits are provided with a plurality of contacts and packaged, or when interconnects are formed between semiconductor circuits on two or more silicon substrates, the conductive circuit to be connected is not only required to be resistant to thermal stress, but also needs to control its shape as fine structure.

For instance, if a conductive circuit including lines of different width is formed using a conductive ink composition containing a solvent, the flatness or shape of conductor lines may change in some areas before and after curing, or a height difference of the circuit may develop under the influence of certain factors such as the volatilization rate of the solvent. If connection is achieved while taking into account the influence, the margin for miniaturization may be lost. In attempts to achieve further miniaturization of semiconductor devices or to construct 3D stacking of semiconductor devices, it would be desirable to have a technology of forming a conductive circuit using a conductive ink composition that allows for stricter control of the circuit shape.

### Citation List

Patent Document 1: JP-A 2010-149301
Patent Document 2: JP-A H11-213756
Patent Document 3: JP-A 2007-053109
Patent Document 4: JP-A H07-109501
   (USP 6797772, EP 0647682)

### DISCLOSURE OF INVENTION

An object of the invention is to provide a method for forming a conductive circuit by printing wherein the conductive circuit printed retains its shape before and after curing and has a stress relaxation ability with respect to thermal stress or the like.

The inventors sought for a material capable of meeting the above requirements. Since a silicone rubber-forming material offers a fluidity necessary for an ink composition to be printed without a need for solvent, it is conceived that silicone rubber may be printed to form a conductive circuit which undergoes no shape change after printing and curing and has a stress relaxation ability. Research is thus made on a thixotropic agent for enhancing thixotropy such that the steric shape formed by printing may not deform until it is heat cured.

Since dry silica is most often used for the purpose of enhancing thixotropy, an experiment was first made to add dry silica to silicone rubber. As the amount of silica added increases, thixotropy increases, and electrical resistance also increases. It was thus difficult to obtain a composition which meets both thixotropy and electrical conduction. Then carbon black having a medium resistivity of the order of 1 Ω-cm is added as the thixotropic agent. Quite unexpectedly, it has been found that as the amount of carbon black added increases, thixotropy increases and electrical resistance remains unchanged or rather decreases. It is then possible to control thixotropy without taking into account conductivity.

In one aspect, the invention provides a method for forming a conductive circuit comprising the steps of printing a pattern using a conductive ink composition and heat curing the pattern into a conductive circuit. The conductive circuit-forming ink composition comprises an addition type silicone resin precursor in combination with a curing catalyst, conductive particles, and a thixotropic agent selected from the group consisting of carbon black, zinc white, tin oxide, tin-antimony oxide, and silicon carbide, and is substantially solvent-free such that when a pattern of dots shaped to have a diameter of 0.8 mm and a height of 0.4 mm is printed and heat cured at 80 to 200°C, the dot shape may experience a change of height within 5% on comparison between the shape as printed and the shape as cured.

In a preferred embodiment, the addition type silicone resin precursor in combination with a curing catalyst is a combination of an organopolysiloxane containing at least two silicon-bonded alkenyl groups, an organohydrogenpolysiloxane containing at least two silicon-bonded hydrogen atoms, and a hydrosilylation reaction catalyst. The conductive particles are preferably selected from among gold particles, silver particles, copper particles, gold-plated particles, silver-plated particles, and copper-plated particles. The thixotropic agent is typically carbon black. The printing step is preferably by screen printing.

Also contemplated herein is a conductive circuit which has been formed by the method defined above.

### ADVANTAGEOUS EFFECTS OF INVENTION

The method of the invention ensures that a conductive circuit is formed from a thixotropic ink composition by printing techniques, typically screen printing. The circuit as printed retains its shape even during the cure step following printing, leading to high-level control of the circuit shape. Because of the silicone rubber-based structure, the circuit has a stress relaxation ability with respect to thermal stress or the like.

### DESCRIPTION OF PREFERRED EMBODIMENTS

The circuit-imaging ink composition used herein is substantially solvent-free and defined as comprising a silicone resin precursor in combination with a curing catalyst, conductive particles, and a thixotropic agent.

For high-precision control of the shape of a conductive circuit pattern during printing and subsequent curing, it is desirable to cure the pattern formed in the printing step while maintaining the pattern shape unchanged. To this end, the conductive circuit-printing ink composition should be selected from those materials capable of minimizing the generation of volatile components for the duration from printing step to the completion of curing step. The ink composition should be prepared substantially without using a solvent.

### Combination of silicone resin precursor with curing catalyst

Curable silicone materials are divided into condensation and addition types in terms of cure mechanism. Silicone resin-forming materials of the addition type are best suited for the object of the invention because they may be cured without outgassing. In order that a patterning material be cured while maintaining the shape as printed intact, it is preferred that the material be curable under mild conditions below 200°C, especially below 150°C. Silicone resin-forming materials of the addition type meet this requirement as well. Notably, the term "silicone resin" is used herein in a broad sense including silicone rubber and silicone resin.

As to the combination of an addition type silicone resin precursor with a curing catalyst, numerous materials are known in the art as described in Patent Document 3, for example. Preferred materials are exemplified below.

The material which is most preferred as the addition type silicone resin precursor is a mixture of an organopolysiloxane containing at least two silicon-bonded alkenyl groups and an organohydrogenpolysiloxane containing at least two silicon-bonded hydrogen atoms. They are described in detail below.

### A) Organopolysiloxane containing at least two alkenyl groups

The organopolysiloxane containing at least two alkenyl groups is represented by the average compositional formula (1):

RₐR'_{b}SiO_{(4-a-b)/2} (1)

wherein R is alkenyl, R' is a substituted or unsubstituted monovalent hydrocarbon group of 1 to 10 carbon atoms free of aliphatic unsaturation, a and b are numbers in the range: 0 < a ≤ 2, 0 < b < 3, and 0 < a+b ≤ 3.

The alkenyl-containing organopolysiloxane serves as component (A) or a base polymer in the composition. This organopolysiloxane contains on average at least 2 (typically 2 to about 50), preferably 2 to about 20, and more preferably 2 to about 10 silicon-bonded alkenyl groups per molecule. Exemplary of the alkenyl group R are vinyl, allyl, butenyl, pentenyl, hexenyl and heptenyl, with vinyl being most preferred. The alkenyl groups are attached to the organopolysiloxane at the ends and/or side chains of its molecular chain.

The organopolysiloxane as component (A) contains a silicon-bonded organic group R' other than alkenyl. Examples of the organic group R' include alkyl groups such as methyl, ethyl, propyl, butyl, pentyl, hexyl and heptyl; aryl groups such as phenyl, tolyl, xylyl, and naphthyl; aralkyl groups such as benzyl and phenethyl; and haloalkyl groups such as chloromethyl, 3-chloropropyl, and 3,3,3-trifluoropropyl. Inter alia, methyl and phenyl are preferred.

The organopolysiloxane as component (A) has a molecular structure which may be linear, partially branched linear, cyclic, branched or three-dimensional network. The preferred organopolysiloxane is a linear diorganopolysiloxane having a backbone consisting of recurring diorganosiloxane units (D units) and capped with triorganosiloxy groups at both ends of the molecular chain, or a mixture of a linear diorganopolysiloxane and a branched or three-dimensional network organopolysiloxane.

The resinous (branched or three-dimensional network) organopolysiloxane is not particularly limited as long as it is an organopolysiloxane comprising alkenyl groups and SiO_{4/2} units (Q units) and/or R"SiO_{3/2} units (T units) wherein R" is R or R'. Examples include a resinous organopolysiloxane consisting of Q units (SiO_{4/2} units) and M units (RR'₂SiO_{1/2} units or R'₃SiO_{1/2} units) in a M/Q molar ratio of 0.6 to 1.2, and a resinous organopolysiloxane consisting of T units and M and/or D units. In the practice of the invention, the resinous organopolysiloxane is not added in large amounts because the composition containing a resinous organopolysiloxane may have a higher viscosity enough to prevent heavy loading of silver powder. Preferably the linear diorganopolysiloxane and the resinous organopolysiloxane are mixed in a weight ratio between 70:30 and 100:0, more preferably between 80:20 and 100:0.

The subscripts a and b are numbers in the range: 0 < a ≤ 2, preferably 0.001 ≤ a ≤ 1, 0 < b < 3, preferably 0.5 ≤ b ≤ 2.5, and 0 < a+b ≤ 3, preferably 0.5 ≤ a+b ≤ 2.7.

The organopolysiloxane as component (A) has a viscosity at 23°C in the range of preferably 100 to 5,000 mPa-s, more preferably 100 to 1,000 mPa-s because the resulting composition is easy to handle and work and the resulting silicone rubber has favorable physical properties. When a linear diorganopolysiloxane and a resinous organopolysiloxane are used in admixture, a homogeneous mixture should preferably have a viscosity in the range. Since the resinous organopolysiloxane dissolves in the linear organopolysiloxane, they may be mixed into a homogeneous mixture. Notably, the viscosity is measured by a rotational viscometer.

Examples of the organopolysiloxane as component (A) include, but are not limited to, trimethylsiloxy-endcapped dimethylsiloxane/ methylvinylsiloxane copolymers, trimethylsiloxy-endcapped methylvinylpolysiloxane, trimethylsiloxy-endcapped dimethylsiloxane/ methylvinylsiloxane/methylphenylsiloxane copolymers, dimethylvinylsiloxy-endcapped dimethylpolysiloxane, dimethylvinylsiloxy-endcapped methylvinylpolysiloxane, dimethylvinylsiloxy-endcapped dimethylsiloxane/ methylvinylsiloxane copolymers, dimethylvinylsiloxy-endcapped dimethylsiloxane/ methylvinylsiloxane/methylphenylsiloxane copolymers, trivinylsiloxy-endcapped dimethylpolysiloxane, organosiloxane copolymers consisting of siloxane units of the formula: R¹₃SiO_{0.5}, siloxane units of the formula: R¹₂R²SiO_{0.5}, siloxane units of the formula: R¹₂SiO, and siloxane units of the formula: SiO₂,
organosiloxane copolymers consisting of siloxane units of the formula: R¹₃S₁O_{0.5}, siloxane units of the formula: R¹₂R²SiO_{0.5}, and siloxane units of the formula: SiO₂,
organosiloxane copolymers consisting of siloxane units of the formula: R¹₂R²SiO_{0.5}, siloxane units of the formula: R¹₂SiO, and siloxane units of the formula: SiO₂,
organosiloxane copolymers consisting of siloxane units of the formula: R¹R²SiO, siloxane units of the formula: R¹SiO_{1.5}, and siloxane units of the formula: R²SiO_{1.5}, and mixtures of two or more of the foregoing.
As used herein and throughout the disclosure, the term "endcapped" means that a compound is capped at both ends with the indicated group unless otherwise stated.

In the above formulae, R¹ is a monovalent hydrocarbon group other than alkenyl, examples of which include alkyl groups such as methyl, ethyl, propyl, butyl, pentyl, hexyl and heptyl; aryl groups such as phenyl, tolyl, xylyl, and naphthyl; aralkyl groups such as benzyl and phenethyl; and haloalkyl groups such as chloromethyl, 3-chloropropyl, and 3,3,3-trifluoropropyl. R² is an alkenyl group such as vinyl, allyl, butenyl, pentenyl, hexenyl or heptenyl.

### B) Organohydrogenpolysiloxane containing at least two hydrogen atoms

The organohydrogenpolysiloxane containing at least two silicon-bonded hydrogen atoms serving as component (B) contains at least 2 (typically 2 to about 300), preferably at least 3 (typically 3 to about 150), and more preferably 3 to about 100 silicon-bonded hydrogen atoms, i.e., SiH groups per molecule. It may be linear, branched, cyclic or three-dimensional network (or resinous). The organohydrogenpolysiloxane preferably has the average compositional formula (2):

H_{c}R³_{d}SiO_{(4-c-d)/2} (2)

wherein R³ is each independently a substituted or unsubstituted monovalent hydrocarbon group free of aliphatic unsaturation or an alkoxy group, c and d are numbers in the range: 0 < c < 2, 0.8 ≤ d ≤ 2, and 0.8 < c+d ≤ 3. Preferably, c and d are numbers in the range: 0.05 ≤ c ≤ 1, 1.5 ≤ d ≤ 2, and 1.8 ≤ c+d ≤ 2.7. The number of silicon atoms per molecule or the degree of polymerization is preferably 2 to 100, more preferably 3 to 50.

Examples of the monovalent hydrocarbon group free of aliphatic unsaturation, represented by R³, include the same groups as exemplified for R', and alkoxy groups such as methoxy and ethoxy. Suitable substituted monovalent hydrocarbon groups include epoxy-containing monovalent hydrocarbon groups. Typical monovalent hydrocarbon groups are those of 1 to 10 carbon atoms, preferably 1 to 7 carbon atoms, and specifically lower alkyl groups of 1 to 3 carbon atoms such as methyl, 3,3,3-trifluoropropyl, and alkoxy groups of 1 to 4 carbon atoms. Suitable epoxy-containing monovalent hydrocarbon groups include the foregoing unsubstituted monovalent hydrocarbon groups, specifically alkyl groups, in which one or more hydrogen atom is replaced by glycidyl or glycidoxy. More preferably R³ is methyl, methoxy, ethoxy, or an epoxy-containing monovalent hydrocarbon group.

Examples of the organohydrogenpolysiloxane include, but are not limited to, siloxane oligomers such as 1,1,3,3-tetramethyldisiloxane, 1,3,5,7-tetramethyltetracyclosiloxane, 1,3,5,7,8-pentamethylpentacyclosiloxane, methylhydrogencyclopolysiloxane, methylhydrogensiloxane/dimethylsiloxane cyclic copolymers, and tris(dimethylhydrogensiloxy)methylsilane; trimethylsiloxy-endcapped methylhydrogenpolysiloxane, trimethylsiloxy-endcapped dimethylsiloxane/ methylhydrogensiloxane copolymers, silanol-endcapped methylhydrogenpolysiloxane, silanol-endcapped dimethylsiloxane/methylhydrogensiloxane copolymers, dimethylhydrogensiloxy-endcapped dimethylpolysiloxane, dimethylhydrogensiloxy-endcapped methylhydrogenpolysiloxane, and dimethylhydrogensiloxy-endcapped dimethylsiloxane/ methylhydrogensiloxane copolymers; and silicone resins comprising R³₂(H)SiO_{1/2}, units, SiO_{4/2} units, and optionally R³₃SiO_{1/2} units, R³₂SiO_{2/2} units, R³(H)SiO_{2/2} units, (H)SiO_{3/2} units or R³SiO_{3/2} units wherein R³ is as defined above. Also included are substituted forms of the above illustrated compounds in which some or all methyl is replaced by alkyl (such as ethyl or propyl) as well as the compounds shown below. 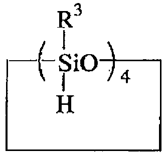 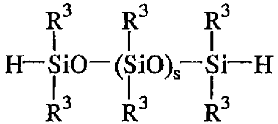 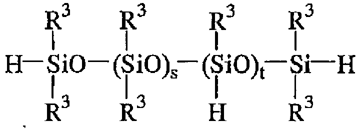 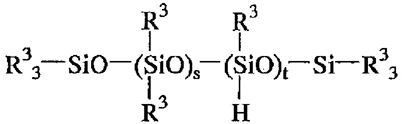 Herein R³ is as defined above, s and t each are 0 or an integer of at least 1.

Where adhesion is crucial, an organohydrogenpolysiloxane containing an alkoxy group and/or epoxy group in a molecule, as represented by the following formula (3) or (4), is preferably used as part or the entirety of component (B). In particular, an organohydrogenpolysiloxane containing alkoxy and epoxy groups in a molecule, as represented by formula (4), is effective for the adhesion improving purpose.

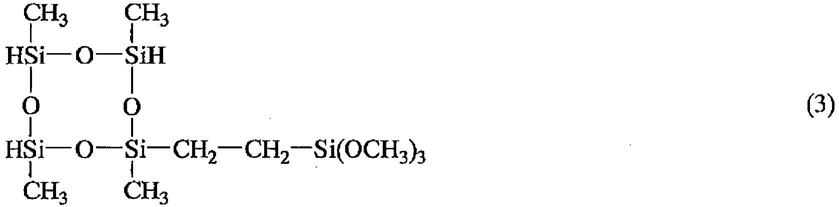

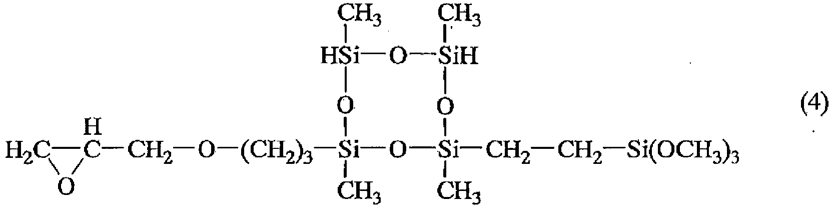

The organohydrogenpolysiloxane used herein may be prepared by any known methods. For example, it may be obtained from (co)hydrolysis of at least one chlorosilane selected from R³SiHCl₂ and R³₂SiHCl (wherein R³ is as defined above) or cohydrolysis of the chlorosilane in admixture with at least one chlorosilane selected from R³₃SiCl and R³₂SiCl₂ (wherein R³ is as defined above), followed by condensation. The polysiloxane obtained from (co)hydrolysis and condensation may be equilibrated into a product, which is also useful as the organohydrogenpolysiloxane.

Component (B) is preferably used in such amounts as to give 0.5 to 5.0 moles, more preferably 0.7 to 3.0 moles of silicon-bonded hydrogen per mole of silicon-bonded alkenyl groups in component (A). Outside the range, the cured product having sufficient strength may not be obtained because of unbalanced crosslinking.

### C) Curing catalyst

The curing catalyst, also referred to as addition or hydrosilylation reaction catalyst, is a catalyst for promoting addition reaction between alkenyl groups in component (A) and silicon-bonded hydrogen atoms (i.e., SiH groups) in component (B). For hydrosilylation reaction, any well-known catalysts such as platinum group metal based catalysts may be used.

Any well-known platinum group metal based catalysts of platinum, rhodium, palladium or the like may be used as the hydrosilylation reaction catalyst. Examples include platinum group metals alone such as platinum black, rhodium, and palladium; platinum chloride, chloroplatinic acid and chloroplatinic acid salts such as H₂PtCl₄·yH₂O, H₂PtCl₆·yH₂O. NaHPtCl₆·yH₂O, KHPtCl₆·yH₂O, Na₂PtCl₆·yH₂O, K₂PtCl₄·yH₂O, PtCl₄·yH₂O, PtCl₂, and Na₂HPtCl₄·yH₂O wherein y is an integer of 0 to 6, preferably 0 or 6; alcohol-modified chloroplatinic acid (USP 3220972); chloroplatinic acid-olefin complexes (USP 3159601, 3159662, and 3775452); platinum group metals such as platinum black and palladium on supports such as alumina, silica and carbon; rhodium-olefin complexes;
chlorotris(triphenylphosphine)rhodium (Wilkinson catalyst); and complexes of platinum chloride, chloroplatinic acid and chloroplatinic acid salts with vinyl-containing siloxanes, especially vinyl-containing cyclosiloxanes. Of these, from the standpoints of compatibility and chlorine impurity, preference is given to silicone-modified chloroplatinic acid, specifically a platinum catalyst obtained by modifying chloroplatinic acid with tetramethyldivinyldisiloxane. The catalyst is added in such amounts as to give 1 to 500 ppm, preferably 3 to 100 ppm, and more preferably 5 to 80 ppm of platinum atom based on the total weight of the ink composition components.

### D) Conductive particles

Conductive particles are contained in the conductive ink composition. It is noted that the term "powder" is sometimes used as a collection of particles. The conductive particles include metal particles such as gold, silver, copper, and aluminum particles, metallized particles such as gold, silver, and copper-plated particles, especially silver-plated silica particles. Of these, silver particles are preferred for high conductivity. The conductive particles preferably have a particle size of several microns (µm) to ten or more microns. Inclusion of coarse particles having a size in excess of 50 µm is not preferable because coarse particles may clog openings of a printing screen.

Where metal particles are used as the conductive particles, they are preferably of flake shape for a balance of flow and conductivity. Particles of another shape are also applicable as long as the amount thereof is properly adjusted. In the embodiment wherein the structure material is a combination of addition type silicone resin precursor with platinum catalyst, the conductive particles should have been carefully surface treated in order that platinum maintain its catalytic activity. In some cases, for example, metal particles are surface treated with an amine compound as anti-flocculation agent. However, the amine compound can poison the platinum catalyst and interfere with cure. Therefore the surface treatment of conductive particles should be performed in a way that allows the platinum catalyst to maintain its activity. Surface treatment not using amine compounds is appropriate, for example, surface treatment of conductive particles with a silicone resin (Patent Document 4), or addition of an additive capable of trapping the amine compound.

As to the metallized particles, particles consisting of copper, aluminum or silica cores plated with gold, silver or the like are commercially available. Although any such metallized particles may be used herein, silver-plated silica particles are preferred because the ink composition loaded therewith has good shelf stability.

The conductive powder is preferably added to the ink composition in an amount of 100 to 1,500 parts, more preferably 300 to 1,000 parts by weight per 100 parts by weight of component (A). The composition containing less than 100 pbw of the conductive powder may form silicone rubber having a low conductivity whereas the composition containing more than 1,500 pbw of the conductive powder may be difficult to handle.

### E) Thixotropic agent

A thixotropic agent is contained in the ink composition. It imparts thixotropy to the ink composition and ensures that the conductive circuit pattern maintains its shape from the printing step to the curing step. The thixotropic agent is selected from among carbon black, zinc white, tin oxide, tin-antimony oxide, and silicon carbide (SiC) having a medium electrical resistance, with carbon black being most preferred.

When a pattern having a steric shape is printed using an ink composition, the ink composition must have thixotropy in order to maintain the shape of the ink pattern as printed until the pattern is heat cured. For enhancing the thixotropy of a material having a sufficient fluidity to print, it is a common practice to add a thixotropic agent thereto. The inventors first attempted to add dry silica (NSX-200, Nippon Aerosil Co., Ltd.) as the thixotropy enhancer. It was empirically found that as the amount of silica added is increased, the composition increases not only thixotropy, but also electrical resistance. The attempt failed to formulate a composition meeting both thixotropy and conductivity. With an intention to improve conductivity, the inventors then attempted to add carbon black (HS-100, Denki Kagaku Kogyo K.K.) having a medium value of electrical resistance. Surprisingly, it was found that as the amount of carbon black added is increased, thixotropy increases, and electrical resistance remains unchanged or rather decreases. While conductive silicone compositions having carbon black added thereto are widely known in the art, they mostly have a resistivity of about 1 Ω-cm, which corresponds to an extremely low level of conductivity as compared with the conductivity in a range of 1×10⁻² to 1×10⁻⁵ Ω-cm as intended herein. Although the reason why the addition of carbon black lowers the electrical resistance of a conductive particle-loaded ink composition is not well understood, the use of a thixotropic agent having a medium value of electrical resistance enables to control thixotropy independent of conductivity.

Any carbon black species commonly used in conductive rubber compositions may be used. Examples include acetylene black, conductive furnace black (CF), super-conductive furnace black (SCF), extra-conductive furnace black (XCF), conductive channel black (CC), as well as furnace black and channel black which have been heat treated at high temperatures of 1,500°C to 3,000°C. Of these, acetylene black is most preferred in the practice of the invention because it has a high conductivity due to a low impurity content and fully developed secondary structure.

The thixotropic agent, typically carbon black is preferably used in an amount of 0.5 to 30 parts, more preferably 1 to 20 parts by weight per 100 parts by weight of component (A). It is noted that a choice of a powder having an average particle size of at least 2 µm as the conductive particles is effective for increasing the contact efficiency of conductive particles and facilitates to gain a good conductivity, but a conductive powder with such size takes less advantage from the thixotropy-imparting effect. Then a larger amount of thixotropic agent is necessary. Specifically, the amount of thixotropic agent used in this case is preferably 5 to 30 parts, more preferably 6 to 20 parts by weight per 100 parts by weight of component (A). In either case, a smaller amount of the thixotropic agent may provide poor shape retention whereas a composition containing an excess of the thixotropic agent may have too high a viscosity to handle.

Preferably, the conductive ink composition may further comprise a stabilizer and a tackifier.

### Stabilizer

Preferably a stabilizer is added to the conductive ink composition so that the composition may undergo consistent addition cure. Suitable stabilizers include fatty acids and acetylene compounds. More preferably, fatty acids, fatty acid derivatives, and/or metal salts thereof are added. When fatty acids, fatty acid derivatives, and/or metal salts thereof are used as the stabilizer, the amount of the stabilizer added is preferably 0.1 to 10 parts, more preferably 0.1 to 5 parts by weight per 100 parts by weight of component (A). Less than 0.1 pbw of the stabilizer may fail to ensure a consistent curing behavior after shelf storage whereas more than 10 pbw may adversely affect the addition curability. The preferred fatty acids, fatty acid derivatives, and metal salts thereof are of at least 8 carbon atoms, specifically 8 to 20 carbon atoms.

Suitable fatty acids include caprylic acid, undecylenic acid, lauric acid, myristic acid, palmitic acid, margaric acid, stearic acid, arachic acid, lignoceric acid, cerotic acid, melissic acid, myristoleic acid, oleic acid, linoleic acid, and linolenic acid.

Suitable fatty acid derivatives include fatty acid esters and aliphatic alcohol esters. Suitable fatty acid esters include polyhydric alcohol esters such as esters of the foregoing fatty acids with C₁-C₅ lower alcohols, sorbitan esters, and glycerol esters. Suitable aliphatic alcohol esters include esters of saturated alcohols such as capryl alcohol, lauryl alcohol, myristyl alcohol, and stearyl alcohol, with fatty acids including dibasic acids such as glutaric acid and suberic acid, and tribasic acids such as citric acid.

Suitable fatty acid metal salts include metal salts such as lithium, calcium, magnesium and zinc salts of fatty acids such as caprylic acid, undecylenic acid, lauric acid, myristic acid, palmitic acid, margaric acid, stearic acid, arachic acid, lignoceric acid, cerotic acid, melissic acid, myristoleic acid, oleic acid, linoleic acid, and linolenic acid.

Inter alia, stearic acid and salts thereof are most preferred as the stabilizer. The stabilizer may be added alone or as a premix with the hydrosilylation reaction catalyst.

Besides the foregoing components, any other additives may be added to the conductive ink composition if desired. In particular, a hydrosilylation reaction retarder may be added for the purpose of enhancing storage stability. The reaction retarder may be selected from well-known ones, for example, acetylene compounds, compounds containing at least two alkenyl groups, alkynyl-containing compounds, triallyl isocyanurate and modified products thereof. Inter alia, the alkenyl and alkynyl-containing compounds are desirably used. The reaction retarder is desirably added in an amount of 0.05 to 0.5 part by weight per the total weight (=100 parts by weight) of other components in the ink composition. A less amount of the retarder may fail to exert the effect of retarding hydrosilylation reaction whereas an excess of the retarder may interfere with the cure process.

The ink composition may be prepared, for example, by mixing the foregoing components on a mixer such as planetary mixer, kneader or Shinagawa mixer.

The ink composition has a viscosity and thixotropy index, which are important factors in forming conductive circuits according to the invention. Preferably the ink composition has a viscosity at 23°C of 10 to 500 Pa-s, more preferably 10 to 200 Pa-s, as measured by an E type viscometer at a rotational speed of 10 rpm. An ink composition having a viscosity of less than 10 Pa-s may flow and fail to retain the shape when the composition is dispensed or otherwise applied or when heat cured. An ink composition having a viscosity of more than 500 Pa-s may fail to follow the mask pattern faithfully when dispensed, leaving defects in the pattern. The thixotropy index, which is defined as the ratio of the viscosity at 10 rpm to the viscosity at 20 rpm of the composition at 23°C, is preferably at least 1.1, and more preferably 1.5 to 5.0. A composition having a thixotropy index of less than 1.1 may be difficult to stabilize the shape as applied.

Since the ink composition for use in the conductive circuit-forming method is substantially free of a solvent, the ink composition whose viscosity and thixotropy have been adjusted as above has such physical properties that when a pattern of dots shaped to have a diameter of 0.8 mm and a height of 0.4 mm is printed and heat cured at 80 to 200°C, the dot shape may experience a change of height within 5% on comparison between the shape as printed and the shape as cured. That is, a height change of the dot shape before and after curing is within 5%. The shape retaining ability of an ink composition can be evaluated by comparing the shape as printed with the shape as cured in this way. The shape to be compared is not limited to the dot shape, and a line shape may be used instead. The dot shape is preferably adopted herein because the dot shape follows a sharp change depending on the ability. Values of shape change may be measured by various optical procedures. For example, measurement may be carried out by using a confocal laser microscope, determining the pattern shape as printed prior to cure and the pattern shape as cured, and comparing the maximum height of the pattern relative to the substrate. The composition which is to pass the test does not show a substantial change of the pattern shape even when the holding time from pattern formation by printing to heat curing is varied. For the composition which is to fail the test, the holding time from pattern formation by printing to heat curing may be set arbitrary because this composition undergoes a shape change during the curing step.

The printing technique used in the conductive circuit-forming method is not particularly limited as long as the amount of the ink composition applied can be controlled at a high accuracy. The preferred printing techniques are dispense printing and screen printing. The screen printing technique capable of high accuracy control is more preferred. As long as the viscosity and thixotropy of the ink composition are adjusted in accordance with the mask shape used in printing, the screen printing technique may comply with a pattern size having a minimum line width in the range from several tens of microns to several hundreds of microns (µm).

According to the method, a conductive circuit is formed by printing a circuit pattern using an ink composition as defined herein and heat curing the pattern. To complete the conductive circuit pattern while maintaining the shape as printed intact, the pattern is cured under appropriate conditions, preferably at 100 to 150°C for 1 to 120 minutes. In the curing step, any of well-known heating devices such as hot plate and oven may be selected in accordance with the substrate used. The cured ink composition preferably has a resistivity of up to 1.0×10⁻³ Ω-cm, more preferably up to 5.0×10⁻⁴ Ω-cm.

### EXAMPLE

Examples of the invention are given below by way of illustration and not by way of limitation.

### Examples 1 to 3 & Comparative Examples 1 to 4

### Preparation of ink composition

Ink compositions of Examples 1 to 3 & Comparative Examples 1 to 4 were prepared by mixing amounts of selected components as shown in Tables 1 and 2 on a planetary centrifugal mixer (Thinky Mixer, Thinky Corp.) until uniform. Note that in Tables 1 and 2, the viscosity is measured at 23°C by an E type viscometer (RE80 by Toki Sangyo Co., Ltd.).
(A) Organopolysiloxane containing at least two silicon-bonded alkenyl groups per molecule and having a viscosity of 600 mPa-s
(B-1) Organohydrogenpolysiloxane having a viscosity of 5
   mPa-s at 23°C and a hydrogen gas release of 350 ml/g (B-2) Alkoxy-containing compound of the following formula (4) 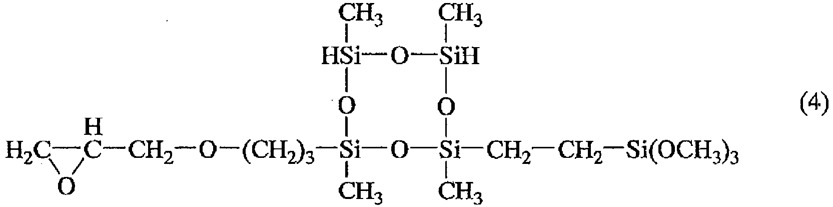
(C) Silver powder (Ag C-237 by Fukuda Metal Foil & Powder Co., Ltd.) which had been acetone washed and dried
(D-1) Denka Black HS-100 (Denki Kagaku Kogyo K.K.)
(D-2) Fumed silica having a BET surface area of 200 m²/g and surface treated with hexamethyldisilazane
(E-1) Platinum catalyst derived from chloroplatinic acid and having tetramethyldivinyldisiloxane ligand (Pt content 1 wt%)
(E-2) Mixture of (E-1) and stearic acid in a weight ratio of 3/2
(F) Stearic acid
Reaction retarder: 1-ethynyl-1-cyclohexanol

### Measurement of conductivity

The ink composition prepared above was cast into a frame to a thickness of 1 mm and cured in an oven at 150°C for 1 hour, yielding a (cured) conductive silicone rubber sheet. The sheet was measured for electrical conductivity using a constant current power supply 237 High Voltage Source Measure Unit and a voltmeter 2000 Multimeter, both of Keithley.

### Shape retention

Shape retention was evaluated using a pattern of dots shaped to have a diameter of about 0.8 mm and a height of 0.4 mm. The ink composition was applied to an aluminum substrate through a punched sheet of Teflon having a thickness of 0.5 mm and an opening diameter of 0.75 mm to form an ink pattern on the substrate. The 3D shape of the ink pattern was observed under a confocal laser microscope VK-9700 (Keyence Corp.). The diameter and the maximum height (relative to the substrate) of dots were measured. Next, the pattern-bearing aluminum substrate was placed in an oven where the dot pattern was cured at 150°C for 1 hour. The maximum height (relative to the substrate) of dots in the cured pattern was measured again using the laser microscope. A ratio (%) of the maximum height of dot pattern as cured to the maximum height of dot pattern prior to cure is reported as shape retention in Tables 1 and 2.

**Table 1**

| Amount (pbw) | | Example | | |
|---|---|---|---|---|
| | | 1 | 2 | 3 |
| (A) | | 90 | 90 | 90 |
| (B-1) | | 2 | 2 | 2 |
| (B-2) | | 6 | 6 | 6 |
| (C) | | 600 | 600 | 600 |
| (D-1) | | 6 | 8 | 10 |
| (D-2) | | - | - | - |
| (E-1) | | - | - | - |
| (E-2) | | 0.33 | 0.33 | 0.33 |
| (F) | | - | - | - |
| Reaction retarder | | 0.2 | 0.2 | 0.2 |
| Results | Volume resistivity (Ω-cm) | 3.0×10⁻⁴ | 2.2×10⁻⁴ | 2.0×10⁻⁴ |
| | Shape retention | 100% | 98% | 98% |

**Table 2**

| Amount (pbw) | | Comparative Example | | | |
|---|---|---|---|---|---|
| | | 1 | 2 | 3 | 4 |
| (A) | | 90 | 90 | 90 | 90 |
| (B-1) | | 2 | 2 | 2 | 2 |
| (B-2) | | 6 | 6 | 6 | 6 |
| (C) | | 600 | 600 | 600 | 600 |
| (D-1) | | 4 | - | - | - |
| (D-2) | | - | - | 2 | 5 |
| (E-1) | | 0.2 | 0.2 | - | - |
| (E-2) | | - | - | 0.33 | 0.33 |
| (F) | | 0.2 | 0.2 | - | - |
| Reaction retarder | | 0.2 | 0.2 | 0.2 | 0.2 |
| Results | Volume resistivity (Ω-cm) | 3.0×10⁻⁴ | 4.7×10⁻⁴ | 6.9×10⁻⁴ | 2.9×10⁻² |
| | Shape retention | 88% | × | 70% | 98% |

| | | | | | |
|---|---|---|---|---|---|
| ×: unmeasurable because no pattern could be formed | | | | | |

## Claims

1. A method for forming a conductive circuit comprising the steps of printing a pattern using a conductive ink composition and heat curing the pattern into a conductive circuit,
the conductive circuit-forming ink composition comprising an addition type silicone resin precursor in combination with a curing catalyst, conductive particles, and a thixotropic agent selected from the group consisting of carbon black, zinc white, tin oxide, tin-antimony oxide, and silicon carbide, and being substantially solvent-free such that when a pattern of dots shaped to have a diameter of 0.8 mm and a height of 0.4 mm is printed and heat cured at 80 to 200°C, the dot shape may experience a change of height within 5% on comparison between the shape as printed and the shape as cured.

2. The method of claim 1 wherein said addition type silicone resin precursor in combination with a curing catalyst is a combination of an organopolysiloxane containing at least two silicon-bonded alkenyl groups, an organohydrogenpolysiloxane containing at least two silicon-bonded hydrogen atoms, and a hydrosilylation reaction catalyst.

3. The method of claim 1 or 2 wherein the conductive particles are selected from the group consisting of gold particles, silver particles, copper particles, gold-plated particles, silver-plated particles, and copper-plated particles.

4. The method of any one of claims 1 to 3 wherein the thixotropic agent is carbon black.

5. The method of any one of claims 1 to 4 wherein the printing step includes screen printing.

6. A conductive circuit which has been formed by the method of any one of claims 1 to 5.

## Patentansprüche

1. Verfahren zur Bildung einer leitfähigen Schaltung, umfassend die Schritte des Druckens eines Musters unter Verwendung einer leitfähigen Tintenzusammensetzung und Wärmehärten des Musters zu einer leitfähigen Schaltung,
wobei die leitfähige, schaltungsbildende Tintenzusammensetzung einen Siliconharz-Vorläufer vom Additionstyp in Kombination mit einem Härtungskatalysator, leitfähige Teilchen und ein thixotropes Mittel umfasst, gewählt aus der Gruppe, bestehend aus Ruß, Zinkweiß, Zinnoxid, Zinn-Antimonoxid und Siliciumcarbid, und im Wesentlichen lösungsmittelfrei ist, so dass, wenn ein Muster aus Punkten, so gebildet, dass sie einen Durchmesser von 0,8 mm und eine Höhe von 0,4 mm aufweisen, gedruckt und bei 80 bis 200°C wärmegehärtet wird, die Punktform eine Höhenänderung innerhalb 5 % erfahren kann, beim Vergleich zwischen der Form, wie gedruckt und der Form, wie gehärtet.

2. Verfahren nach Anspruch 1, wobei der Siliconharz-Vorläufer vom Additionstyp in Kombination mit einem Härtungskatalysator eine Kombination aus einem Organopolysiloxan, enthaltend mindestens zwei siliciumgebundene Alkenylgruppen, einem Organohydrogenpolysiloxan, enthaltend mindestens zwei siliciumgebundene Wasserstoffatome, und einem Hydrosilyierungs-Reaktionskatalysator ist.

3. Verfahren nach Anspruch 1 oder 2, wobei die leitfähigen Teilchen gewählt sind aus der Gruppe, bestehend aus Goldteilchen, Silberteilchen, Kupferteilchen, goldplattierten Teilchen, silberplattierten Teilchen und kupferplattierten Teilchen.

4. Verfahren nach mindestens einem der Ansprüche 1 bis 3, wobei das thixotrope Mittel Ruß ist.

5. Verfahren nach mindestens einem der Ansprüche 1 bis 4, wobei der Druckschritt Siebdrucken beinhaltet.

6. Leitfähige Schaltung, welche durch das Verfahren gemäß mindestens einem der Ansprüche 1 bis 5 gebildet worden ist.

## Revendications

1. Procédé de formation d'un circuit conducteur comprenant les étapes d'impression d'un motif en utilisant une composition d'encre conductrice et de durcissement à la chaleur du motif en un circuit conducteur,
la composition d'encre formant un circuit conducteur comprenant un précurseur de résine de silicone de type addition en combinaison avec un catalyseur de durcissement, des particules conductrices et un agent thixotrope sélectionné dans le groupe constitué par le noir de carbone, le blanc de zinc, l'oxyde d'étain, l'oxyde d'étain-antimoine et le carbure de silicium, et étant sensiblement dépourvu de solvant de sorte que lorsqu'un motif de points formés pour avoir un diamètre de 0,8 mm et une hauteur de 0,4 mm est imprimé et durci à la chaleur à 80 à 200 °C, la forme des points peut subir un changement de hauteur de l'ordre de 5 % comparativement entre la forme imprimée et la forme durcie.

2. Procédé selon la revendication 1, dans lequel ledit précurseur de résine de silicone de type addition en combinaison avec un catalyseur de durcissement est une combinaison d'un organopolysiloxane contenant au moins deux groupes alcényle liés à un atome de silicium, d'un organohydrogénopolysiloxane contenant au moins deux atomes d'hydrogène liés à un atome de silicium et d'un catalyseur de réaction d'hydrosilylation.

3. Procédé selon la revendication 1 ou 2, dans lequel les particules conductrices sont sélectionnées dans le groupe constitué par les particules d'or, les particules d'argent, les particules de cuivre, les particules plaquées or, les particules plaquées argent et les particules plaquées cuivre.

4. Procédé selon l'une quelconque des revendications 1 à 3, dans lequel l'agent thixotrope est le noir de carbone.

5. Procédé selon l'une quelconque des revendications 1 à 4, dans lequel l'étape d'impression comprend la sérigraphie.

6. Circuit conducteur qui a été formé par le procédé selon l'une quelconque des revendications 1 à 5.
